# EUROPEAN PATENT APPLICATION

(11) **EP 4 734 728 A1**
(43) Date of publication of application: **29.04.2026**
(21) Application number: 25724915.1
(22) Date of filing: 26.03.2025
(51) Int. Cl.: H10K 71/12, H10K 85/50, H10K 30/50

(54) **MANUFACTURING METHOD FOR PEROVSKITE SOLAR CELL AND PEROVSKITE SOLAR CELL**

(30) Priority: 08.08.2024 CN 202411088386
(71) Applicant: Advanced Solar Technology Institute, Xuancheng, Xuancheng, Anhui 242000 (CN)
(72) Inventor: BI, Enbing, Xuancheng, Anhui 242000 (CN); HAIDER, Mustafa, Xuancheng, Anhui 242000 (CN); GUO, Ted Tie, Xuancheng, Anhui 242000 (CN)
(74) Representative: Groth & Co. KB
(86) International application number: PCT/CN2025/085063
(87) International publication number: WO 2026/031579

(57) **Abstract**

The present application relates to the technical field of solar cell manufacturing. The present application particularly relates to a method for manufacturing a perovskite solar cell and a perovskite solar cell. The formation of the perovskite layer of the perovskite solar cell comprises the following steps: forming an inorganic precursor solution and further forming an inorganic precursor membrane layer, wherein solvent of the inorganic precursor solution comprises a mixture of DMF and DMSO, wherein an inorganic precursor material forming the inorganic precursor solution comprises at least CsX and PbX₂; forming an organic precursor solution, applying the organic precursor solution on a surface of the inorganic precursor membrane layer, and mixing with the inorganic precursor membrane layer to form a mixed precursor solution layer, wherein an organic precursor material of the organic precursor solution comprises at least two of FAX and MAX; and performing diffusion annealing to transform the mixed precursor solution layer into the perovskite layer. According to the method for manufacturing the perovskite solar cell provided by the present application, the perovskite solar cell with a wide-band-gap perovskite layer can be manufactured through a double-solution diffusion method.

## Description

### CROSS REFERENCE TO RELATED APPLICATIONS

The present application claims priority to Chinese Patent Application No. 202411088386.6 filed on August 8, 2024, the entire contents of which are incorporated herein by reference.

### TECHNICAL FIELD

The present application relates to the technical field of solar cell manufacturing, and in particular to a method for manufacturing a perovskite solar cell and a perovskite solar cell.

### BACKGROUND

Solar energy is renewable and clean, with abundant availability and cost-effectiveness. Converting solar energy into electrical energy using photovoltaic cells is one of the most efficient utilization methods currently used. It is worth noting that solar cells, especially those composed of polycrystalline silicon and single-crystalline silicon, already have mature industrial technology. However, in recent years, there has been a surge focus on perovskite solar cells in scientific and industrial fields due to their remarkable properties, including high photoelectric conversion efficiency, adjustable band gap width, strong tolerance to impurities, lowest temperature coefficient and simple preparation procedures. The efficiency of perovskite/crystalline silicon tandem solar cells has now reached an impressive 33.9%, exceeding the 26.8% of single-junction devices.

The formation of a perovskite layer is of great significance for achieving higher solar cell efficiency, especially when considering perovskites with wide band gap used in the formation of tandem solar cells. In the prior art, one of the methods for the formation of a perovskite layer is a full solution method (double-solution inter-diffusion method). Among them, the double-solution diffusion method comprises a stratified method, first forming an inorganic precursor membrane or template (a template refers to a structure including a substrate and a liquid membrane after an inorganic precursor solution is spreaded on a substrate to form a membrane), and then forming an organic membrane and then mixing to form a perovskite absorption layer. This method encounters challenges in controlling carrier dynamics in the formation of a perovskite layer with wide band gap, and it is difficult to achieve the preparation of a perovskite layer with accurate band gap. Especially in the presence of relatively large halide ions, such as bromide, the uniformity of the perovskite layer is not good, and defects are prone to occur, resulting in the final product with band gap deviating from the design value, causing unsatisfactory photoelectric conversion performance of the final solar cell. Therefore, it is urgent to solve the application of this method for a perovskite layer with wide band gap.

### SUMMARY OF THE INVENTION

Therefore, the present application provides a method for manufacturing a perovskite solar cell and a perovskite solar cell to solve the problem that it is difficult to achieve an accurate band gap when preparing a perovskite layer with wide band gap.

The present application provides a method for manufacturing a perovskite solar cell. The formation of the perovskite layer of the perovskite solar cell comprises the following steps: forming an inorganic precursor solution and further forming an inorganic precursor membrane layer, wherein solvent of the inorganic precursor solution comprises a mixture of N,N-dimethylformamide (DMF) and dimethyl sulfoxide (DMSO), wherein an inorganic precursor material forming the inorganic precursor solution comprises at least CsX and PbX₂, and wherein X in CsX is Br or I, and X in PbX₂ is I; forming an organic precursor solution, applying the organic precursor solution on a surface of the inorganic precursor membrane layer, and mixing with the inorganic precursor membrane layer to form a mixed precursor solution layer, wherein an organic precursor material of the organic precursor solution comprises at least two of formamidinium halides (FAX) and methylamine halides (MAX), and wherein X in FAX is Br or I, and X in MAX is Cl; and performing diffusion annealing to transform the mixed precursor solution layer into the perovskite layer.

Optionally, the step of forming an inorganic precursor solution and further forming an inorganic precursor membrane layer comprises: mixing two or more inorganic precursor materials according to their corresponding preset molar contents, and modulating to form the inorganic precursor solution; spreading the inorganic precursor solution on a substrate to form into a inorganic layer, wherein the spreading mode comprises spin coating; and performing annealing to the spreaded inorganic precursor solution to form the inorganic precursor membrane layer, wherein the inorganic precursor membrane layer is a liquid membrane layer.

Optionally, in the inorganic precursor solution, a molar content of CsX and a molar content of PbX₂ are different. The molar content of CsX is in a range from 0.10 mol/L to 0.20 mol/L; the molar content of PbX₂ is in a range from 1.00 mol/L to 2.00 mol/L; and in the mixture of DMF and DMSO solvent, a ratio of DMF to DMSO is in a range from (900:100) to (990:10).

Optionally, in the mixture of DMF and DMSO solvent, the ratio of DMF to DMSO is 950:50; and in the inorganic precursor solution, a difference between the molar content of CsX and the molar content of PbX₂ is 0.1 mol/L.

Optionally, the step of, forming an organic precursor solution, applying the organic precursor solution on a surface of the inorganic precursor membrane layer, and mixing with the inorganic precursor membrane layer to form a mixed precursor solution layer, comprises: mixed and stir at least two organic precursor materials into the organic precursor solution according to corresponding preset molar contents, wherein the solvent of the organic precursor solution comprises isopropanol (IPA); and spreading the organic precursor solution on the surface of the inorganic precursor membrane layer and mixing, wherein the spreading mode comprises spin coating.

Optionally, in the step of performing diffusion annealing to transform the mixed precursor solution layer into the perovskite layer, an annealing temperature is in a range from 100 °C to 200 °C, an annealing time is in a range from 10 min to 60 min, and an ambient humidity is in a range from 20% to 60% relative humidity.

Optionally, the method for manufacturing a perovskite solar cell further comprises: providing a substrate layer; forming an i-type hydrogenated amorphous silicon layer, a P-type amorphous silicon doping layer, a first transparent electrode layer and a first metal electrode layer laminated in sequence on a surface of one side of the substrate layer; and forming an i-type hydrogenated amorphous silicon layer, a N-type amorphous silicon doping layer, a transparent conductive layer, a hole transport layer, a passivation layer, an electron transport layer, a second transparent conductive layer, a second metal electrode layer and an anti-reflection layer laminated in sequence on a surface of the other side of the substrate layer; wherein the perovskite layer is formed on a surface of one side of the hole transport layer facing away from the substrate layer, and the passivation layer is formed on a surface of one side of the perovskite layer facing away from the substrate layer.

The present application also provides a perovskite solar cell, characterized in that it is manufactured using the method for manufacturing a perovskite solar cell provided by the present application; wherein the perovskite solar cell comprises a single-junction perovskite cell device, a perovskite-perovskite laminated cell or a perovskite heterojunction laminated cell and other laminated cells containing a perovskite cell portion.

Optionally, the perovskite solar cell provided by the present application includes: a substrate layer; an i-type hydrogenated amorphous silicon layer, a P-type amorphous silicon doping layer, a first transparent electrode layer and a first metal electrode layer which are laminated in sequence on one side of the substrate layer; an i-type hydrogenated amorphous silicon layer, a N-type amorphous silicon doping layer, a transparent conductive layer, a hole transport layer, a passivation layer, an electron transport layer, an electron transport layer modification layer, a second transparent conductive layer, a second metal electrode layer and an anti-reflection layer which are laminated in sequence on the other side of the substrate layer; and a perovskite layer which is located between the hole transport layer and the passivation layer.

Optionally, the first transparent conductive layer comprises Indium Tin Oxide (ITO) conductive glass or Fluorine-doped Tin Oxide (FTO) conductive glass; the second transparent conductive layer comprises ITO conductive glass or FTO conductive glass; the material of the passivation layer comprises phenylethylamine iodide or ethylamine iodide; the material of the first metal electrode layer comprises one of Au, Ag, Cu, Cu-Al alloy, and C; and the material of the second metal electrode layer comprises one of Au, Ag, Cu, Cu-Al alloy and C.

The technical solution of the present application has the following advantages.

The method for manufacturing the perovskite solar cells provided in the present application establishes a strong inorganic membrane template by combining CsX and PbX₂ (especially PbI₂) in DMF and DMSO, thereby forming a structured substrate to promote the uniform and orderly growth of the perovskite membrane. Subsequently, by using a double-solution diffusion method, combined with the use of organic salts such as FAX and/or MAX, the penetration of the template can be controlled, and the formation of the final perovskite layer is promoted. The method comprises preparing a separate precursor solution with a specific molar ratio of inorganic and organic components, thereby allowing fine control of the halide composition at the molecular level. The deposition process comprises applying the organic precursor solution onto the preformed inorganic precursor membrane layer, and promoting the controlled inter-diffusion of the halide during the annealing process to achieve the desired halide distribution. By carefully managing the specific concentrations of different halides (iodide and bromide) in the separate precursor solutions, this method provides a unique solution to solve the complexity of halide control in the dual-step deposition method, and finally produces a high-quality perovskite layer with the desired wide band gap properties. The present method enhances the crystallization of perovskites and addresses challenges associated with carrier dynamics, particularly in the presence of relatively large halide ions such as bromide, leading to a structure that is more uniform and less prone to defects. Furthermore, adjusting the ratio of organic precursors in the perovskite enables the realization of different optical band gaps within the perovskite layer.

The perovskite solar cell provided by the present application is manufactured using the method for manufacturing the perovskite solar cell provided by the present application. A strong inorganic membrane template is established by combining CsX and PbX₂ (especially PbI₂) in DMF and DMSO, thereby forming a structured substrate to promote the uniform and orderly growth of the perovskite membrane. Subsequently, by using a double-solution diffusion method, combined with the use of organic salts such as FAX and/or MAX, the penetration of the template can be controlled, and the formation of the final perovskite layer is promoted. The method comprises preparing a separate precursor solution with a specific molar ratio of inorganic and organic components, thereby allowing fine control of the halide composition at the molecular level. The deposition process comprises applying the organic precursor solution onto the preformed inorganic precursor membrane layer, and promoting the controlled inter-diffusion of the halide during the annealing process to achieve the desired halide distribution. By carefully managing the specific concentrations of different halides (iodide and bromide) in the separate precursor solutions, this method provides a unique solution to solve the complexity of halide control in the dual-step deposition method, and finally produces a high-quality perovskite layer with the desired wide band gap properties. The present method enhances the crystallization of perovskites and addresses challenges associated with carrier dynamics, particularly in the presence of relatively large halide ions such as bromide, leading to a structure that is more uniform and less prone to defects. Furthermore, adjusting the ratio of organic precursors in the perovskite enables the realization of different optical band gaps within the perovskite layer.

### BRIEF DESCRIPTION OF THE DRAWINGS

In order to illustrate the technical solutions in the specific embodiments of the present application or in the prior art more clearly, the drawings to be used in the description of the specific embodiments or the prior art will be briefly introduced below. Obviously, the drawings in the following description show some of the embodiments of the present application, and those of ordinary skill in the art may still obtain other drawings from these drawings without creative efforts.
Figure 1 is a schematic flow diagram of a method for manufacturing a perovskite solar cell according to an example of the present application;
Figure 2A and 2B are schematic diagrams of forming an organic precursor membrane layer in a method for manufacturing a perovskite solar cell according to an example of the present application;
Figure 3A and 3B are schematic flow diagrams of forming a mixed precursor membrane layer and transforming it into a perovskite layer in a method for manufacturing a perovskite solar cell according to an example of the present application;
Figure 4 is a J-V characteristic curve diagram of a perovskite solar cell according to a specific example of the present application;
Figure 5A is an electron microscope image of the interface between the perovskite layer and the underlying membrane layer of a perovskite solar cell according to another specific example of the present application;
Figure 5B is a J-V characteristic curve diagram of a perovskite solar cell according to another specific example of the present application.

### DETAILED DESCRIPTION

One of the main challenges facing the dual-step deposition method for perovskite formation is the accurate control of the halide composition, especially when dealing with multiple halides such as iodide and bromine. The mixture of these halides in the second precursor solution can make it difficult to achieve the desired halide ratio in the perovskite structure. This challenge becomes more pronounced when aiming to make perovskites for cells with larger band gap, where the specific halide concentration plays a crucial role in determining the optical properties.

In order to solve the problem that it is difficult to accurately prepare the band gap of a perovskite layer with wide band gap of a perovskite solar cell in the prior art, the present application provides a method for manufacturing a perovskite solar cell and a perovskite solar cell.

The technical solution of the present application will be clearly and completely described below in conjunction with the accompanying drawings. Obviously, the described embodiments are part of the embodiments of the present application, rather than all of the embodiments. Based on the embodiments in the present application, all other embodiments obtained by ordinary technicians in this field without making creative work are within the scope of protection of the present application. In the description of the present application, it should be noted that the terms "first", "second" and "third" are used for descriptive purposes only and cannot be understood as indicating or implying relative importance.

### Example 1

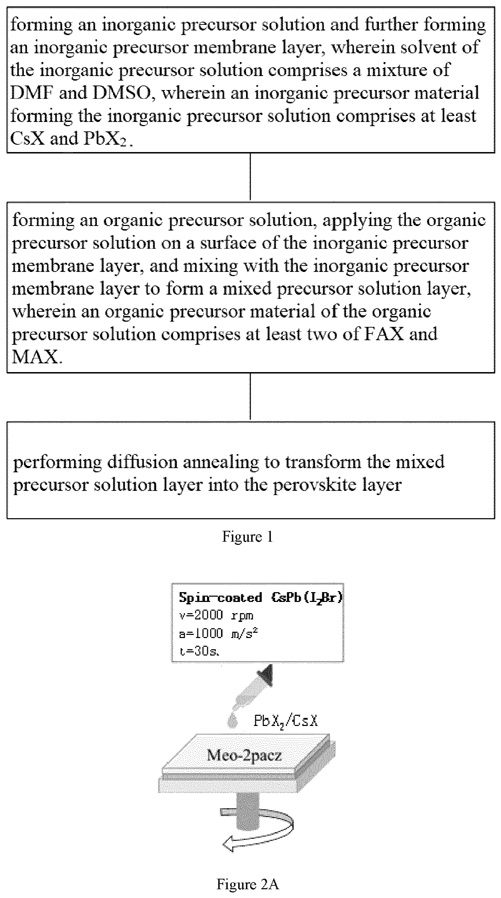

Referring to Figure 1, this example provides a method for manufacturing a perovskite solar cell, wherein the formation of a perovskite layer of the perovskite solar cell comprises the following steps:
forming an inorganic precursor solution and further forming an inorganic precursor membrane layer, wherein solvent of the inorganic precursor solution comprises a mixture of DMF and DMSO, wherein an inorganic precursor material forming the inorganic precursor solution comprises at least CsX and PbX₂, and wherein X in CsX is Br or I, and X in PbX₂ is I;
forming an organic precursor solution, applying the organic precursor solution on a surface of the inorganic precursor membrane layer, and mixing with the inorganic precursor membrane layer to form a mixed precursor solution layer, wherein an organic precursor material of the organic precursor solution comprises at least two of FAX and MAX, and wherein X in FAX is Br or I, and X in MAX is Cl; and
performing diffusion annealing, mixing the inorganic precursor solution and the organic precursor solution more thoroughly to form a mixed precursor solution layer, and transforming the mixed precursor solution layer into a perovskite layer.

The method for manufacturing a perovskite solar cell provided in this example establishes a strong inorganic membrane template by accurately combining CsX and PbX₂ (especially PbI₂) in DMF and DMSO, thereby forming a structured substrate to promote the uniform and orderly growth of the perovskite membrane. Subsequently, by using a double-solution diffusion method, combined with the use of organic salts such as FAX and/or MAX, the penetration of the template can be controlled, and the formation of the final perovskite layer is promoted. The method comprises preparing a separate precursor solution with a specific molar ratio of inorganic and organic components, thereby allowing fine control of the halide composition at the molecular level. The deposition process comprises applying the organic precursor solution onto the preformed inorganic precursor membrane layer, and promoting the controlled inter-diffusion of the halide during the annealing process to achieve the desired halide distribution. By carefully managing the specific concentrations of different halides (iodide and bromide) in the separate precursor solutions, this method provides a unique solution to solve the complexity of halide control in the dual-step deposition method, and finally produces a high-quality perovskite layer with the desired wide band gap properties. The present method enhances the crystallization of perovskites and addresses challenges associated with carrier dynamics, particularly in the presence of relatively large halide ions such as bromine, leading to a structure that is more uniform and less prone to defects. Furthermore, adjusting the ratio of organic precursors in the perovskite enables the realization of different optical band gaps within the perovskite layer.

Furthermore, the step of forming an inorganic precursor solution and further forming an inorganic precursor membrane layer comprises: mixing and stirring two or more inorganic precursor materials according to their corresponding preset molar contents, and modulating to form the inorganic precursor solution; spin coating the inorganic precursor solution on a substrate to form into a first layer, and performing annealing after spin the inorganic precursor solution to form the inorganic precursor layer.

Furthermore, in the inorganic precursor solution, a molar content of CsX and a molar content of PbX₂ are different. The molar content of CsX is in a range from 0.10 mol/L to 0.20 mol/L; the molar content of PbX₂ is in a range from 1.00 mol/L to 2.00 mol/L; in the mixture of DMF and DMSO solvent, a ratio of DMF to DMSO is in a range from (900:100) to (990:10). By accurately controlling the above material range, accurate adjustment of the band gap can be achieved.

Furthermore, in different examples, the molar content of CsX and the molar content of PbX₂ are always different by 0.1 mol/L. In this way, the accurate control among components can be achieved and the band gap can be accurately adjusted.

In an optional example, in the mixed solvent of DMF and DMSO, the ratio of DMF to DMSO is 950:50 (parts), CsI or CsBr is 0.13 mol/L, PbI₂ is 1.3 mol/L. This ratio is helpful for the subsequent accurate adjustment of the band gap of the final perovskite layer by regulating the proportion of organic precursor materials in the organic precursor solution.

Furthermore, the step of, forming an organic precursor solution, applying the organic precursor solution on a surface of the inorganic precursor membrane layer, and mixing with the inorganic precursor membrane layer to form a mixed precursor solution layer, comprises: at least two organic precursor materials into the organic precursor solution according to corresponding preset molar contents, wherein the solvent of the organic precursor solution comprises isopropanol (IPA); and spreading the organic precursor solution on the surface of the inorganic precursor membrane layer and mixing, wherein the spreading mode comprises spin coating.

Furthermore, in the organic precursor solution, the organic precursor material comprises formamidinium iodide (FAI), formamidinium bromide (FABr) and methylamine chloride (MACl); and in the organic precursor solution, the content of FAI is in a range from 0.12 mol/L to 0.22 mol/L, the content of FABr is in a range from 0.16 mol/L to 0.32 mol/L, and the content of MACl is 0.1 mol/L.

In an optional example, the content of FAI is 0.12 mol/L, the content of FABr is 0.32 mol/L, and the content of MACl is 0.1 mol/L. According to this ratio, combined with the ratio of the aforementioned inorganic precursors, a band gap of 1.67 eV can be obtained. In another optional example, the content of FAI is 0.22 mol/L, the content of FABr is 0.16 mol/L, and the content of MACl is 0.1 mol/L. According to this ratio, combined with the ratio of the aforementioned inorganic precursors, a band gap of 1.61 eV can be obtained.

Furthermore, in the step of performing diffusion annealing to transform the mixed precursor solution layer into the perovskite layer, an annealing temperature is in a range from 100 °C to 200 °C; an annealing time is in a range from 10 min to 60 min; and an ambient humidity is in a range from 20% to 60% relative humidity. Within such a range of conditions, it is helpful to mix and transform the various materials and maintain a stable ratio. A ratio lower than the lower limit or higher than the upper limit is not conducive to the accurate control of the ratio.

Furthermore, the method for manufacturing a perovskite solar cell also comprises: providing a substrate layer; forming an i-type hydrogenated amorphous silicon layer, a P-type amorphous silicon doping layer, a first transparent electrode layer and a first metal electrode layer laminated in sequence on a surface of one side of the substrate layer; and forming an i-type hydrogenated amorphous silicon layer, a N-type amorphous silicon doping layer, a transparent conductive layer, a hole transport layer, a passivation layer, an electron transport layer (in different examples, it also may be an electron transport layer modification layer), a second transparent conductive layer, a second metal electrode layer and an anti-reflection layer laminated in sequence on a surface of the other side of the substrate layer; wherein, the perovskite layer is formed on a surface of one side of the hole transport layer facing away from the substrate layer; and the passivation layer is formed on a surface of one side of the perovskite layer facing away from the substrate layer.

### Example 2

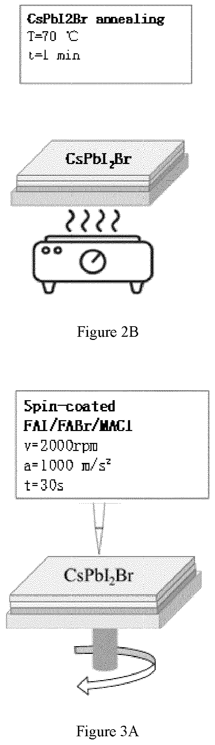

Referring to Figure 2A to Figure 3B, this example is a specific implementation process of manufacturing a solar cell using the method of the above-mentioned Example 1, and the details are as follows.

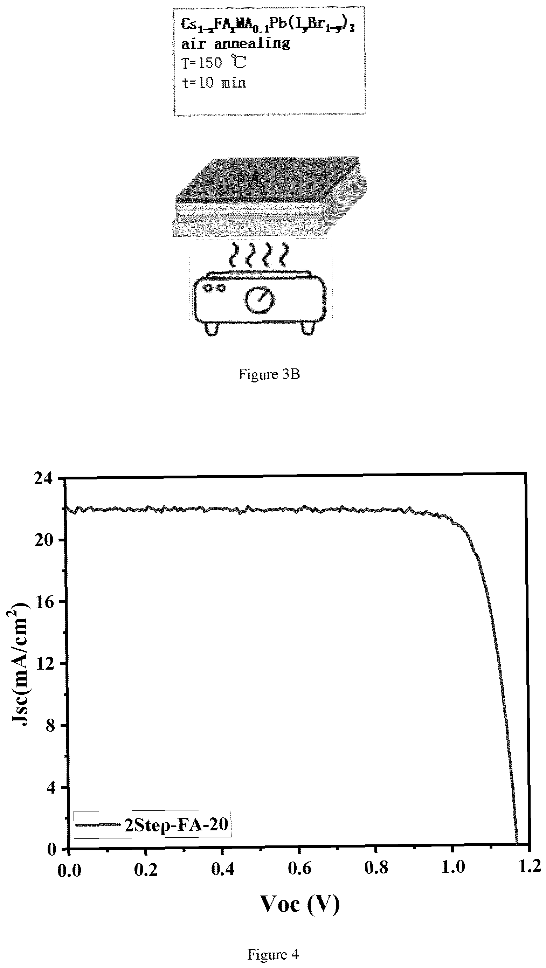

Nickel oxide was prepared on a clean ITO substrate as a hole transport layer, and it was dispersed in deionized water at a concentration of 10 mg/mL to 20 mg/mL, and then it was processed by spin coating. MeO₂Paz was prepared at a concentration of 0.5 mg/mL to 1.0 mg/mL, and it was processed by spin coating. Raw materials based on cesium bromide, iodide and lead iodide were prepared according to a 1.3M molar ratio, dissolved in a mixed solvent of DMF:DMSO=950:50 (molar ratio), stirred for 5 minutes to 10 minutes, then spin-coated on the substrate and annealed at 70°C for one minute to prepare a conformal inorganic template. Raw materials based on formamidine, methylamine iodide and bromide were prepared according to to weight (mg) ratio of FAI: FABr: MACl = 30:40:7 dissolved in isopropanol, stirred for 5 minutes to 10 minutes, and then spin-coated onto the inorganic template. The substrate was placed in a 30% RH environment and annealed at 150°C for 15 minutes to complete the perovskite transformation process. In this experiment, PCBM ([6,6]-phenyl-C61-butyric acid methyl ester) was selected as the electron transport layer. Phenylethylamine iodide (PEAI) with a concentration of 0.5 mg/mL to 1.0 mg/mL was prepared by spin coating. PCBM was dissolved in a chlorobenzene solvent at a concentration of 20 mg/ml and treated by spin coating. Finally, in this experiment, silver was deposited at an evaporation rate of 1 A/s on the electron transport layer as the back electrode with a membrane thickness of 100 nm. The photovoltaic performance parameters of the device are shown in Figure 4 and Table 1 below.

**Table 1. Photovoltaic performance parameters of perovskite solar cells**

| | V_{oc} (V) | J_{sc} (mA/cm²) | FF (%) | PCE (%) |
|---|---|---|---|---|
| Example 2 | 1.168 | 21.638 | 83.273 | 21.05 |

### Example 3

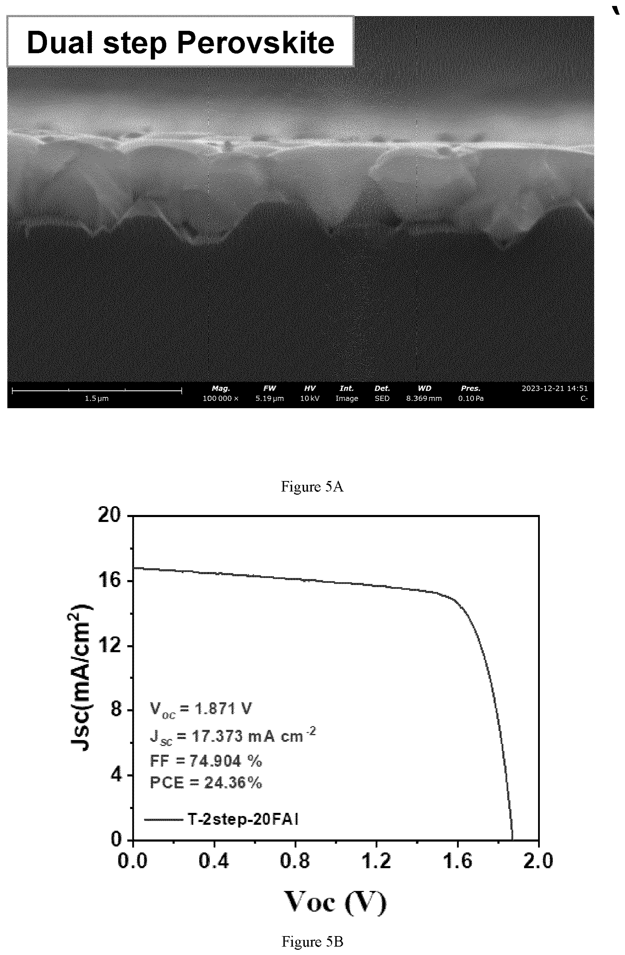

Referring to Figure 1, Figure 5A and Figure 5B, this example is a specific implementation process of manufacturing a solar cell using the method of the above-mentioned Example 1, and the details are as follows.

Firstly, a single-crystalline silicon substrate was provided, and on one surface, an i-type hydrogenated amorphous silicon layer and a P-type amorphous silicon doping layer were sequentially prepared using plasma enhanced chemical vapor deposition (PECVD), wherein the i-type layer has a specific thickness of 5nm, and the P-type layer has a specific thickness of 5nm to 30nm. Subsequently, a first transparent electrode layer having a thickness ranging from 50nm to 500nm was deposited using magnetron sputtering, vacuum evaporation or reactive plasma deposition technology.

Subsequently, a first metal electrode layer with a thickness ranging from 50 nm to 3000 nm was applied on the surface of the first transparent electrode layer using a method such as magnetron sputtering, vacuum evaporation, reactive plasma deposition or printing. On the other surface of the silicon substrate, i-type hydrogenated amorphous silicon layer, N-type amorphous silicon doping layer and transparent conductive oxide (TCO) composite layer were sequentially prepared according to specific thickness requirements using PECVD and methods such as magnetron sputtering, vacuum evaporation, reactive plasma deposition or chemical vapor deposition.

Subsequently, a hole transport layer with a thickness ranging from 0 nm to 50 nm was formed on the TCO composite layer, including treatments with UV, ozone, and the like and techniques such as spin coating, magnetron sputtering and static spin coating of different layers.

The subsequent steps comprise preparing a perovskite absorption layer on the bottom hole transport layer, that is, raw materials based on cesium bromide, iodide and lead iodide were prepared according to 1.3 mol/L, dissolved in a mixed solvent of DMF:DMSO=950:50 (molar ratio), stirred for 5 minutes to 10 minutes, and then spin-coated on the HTL and annealed at 70°C for one minute to prepare a conformal inorganic template. Raw materials based on formamidine, methylamine iodide and bromide were were prepared according to weight (mg) ratio of FAI: FABr: MACl = 30:40:7 dissolved in isopropanol, stirred for 5 minutes to 10 minutes, and then spin-coated onto the inorganic template. The substrate was placed in a 30% RH environment and annealed at 150°C for 15 minutes to complete the perovskite transformation process. Then, vapor deposition technology was used to deposit a top passivation layer with materials such as magnesium fluoride and lithium fluoride. Then, an electron transport layer or an electron transport layer modification layer was prepared on top of the passivation layer, and the specific deposition method and thickness were outlined.

Finally, a second transparent electrode layer and a second metal electrode layer were applied on the electron transport layer modification layer using magnetron sputtering and vapor deposition, respectively. An anti-reflection layer is deposited on the second metal electrode layer to complete the fabrication of the perovskite/crystalline silicon tandem solar cell. Each step in this process involves accurate control of the deposition method, vacuum conditions, temperature, evaporation rate, and material composition to ensure the successful construction of the solar cell structure.

### Example 4

The present application also provides a perovskite solar cell, characterized in that it is manufactured using the method for manufacturing the perovskite solar cell provided by the present application; and the perovskite solar cell comprises a single-junction perovskite cell device, a perovskite-perovskite laminated cell or a perovskite heterojunction laminated cell and other laminated cells containing a perovskite cell portion.

The perovskite solar cell provided in this example is manufactured using the method for manufacturing the perovskite solar cell provided by the present application. A strong inorganic membrane template was established by accurately combining CsX and PbX₂ (especially PbI₂) in DMF and DMSO, thereby forming a structured substrate to promote the uniform and orderly growth of the perovskite membrane. Subsequently, by using a double-solution diffusion method, combined with the use of organic salts such as FAX and/or MAX, the penetration of the template can be controlled, and the formation of the final perovskite layer was promoted. The method comprises preparing a separate precursor solution with a specific molar ratio of inorganic and organic components, thereby allowing fine control of the halide composition at the molecular level. The deposition process comprises applying the organic precursor solution onto the preformed inorganic precursor membrane layer, and promoting the controlled inter-diffusion of the halide during the annealing process to achieve the desired halide distribution. By carefully managing the specific concentrations of different halides (iodide and bromide) in the separate precursor solutions, this method provides a unique solution to solve the complexity of halide control in the dual-step deposition method, and finally produces a high-quality perovskite layer with the desired wide band gap properties. The present method enhances the crystallization of perovskites and addresses challenges associated with carrier dynamics, particularly in the presence of relatively large halide ions such as bromide, leading to a structure that is more uniform and less prone to defects. Furthermore, adjusting the ratio of organic precursors in the perovskite enables the realization of different optical band gaps within the perovskite layer.

Furthermore, the perovskite solar cell provided by the present application comprises: a substrate layer; an i-type hydrogenated amorphous silicon layer, a P-type amorphous silicon doping layer, a first transparent electrode layer and a first metal electrode layer which were sequentially laminated on one side of the substrate layer; an i-type hydrogenated amorphous silicon layer, a N-type amorphous silicon doping layer, a transparent conductive layer, a hole transport layer, a passivation layer, an electron transport layer, an electron transport layer modification layer, a second transparent conductive layer, a second metal electrode layer and an anti-reflection layer which are sequentially laminated on the other side of the substrate layer; and a perovskite layer which is located between the hole transport layer and the passivation layer.

Furthermore, the first transparent conductive layer comprises ITO conductive glass or FTO conductive glass; the second transparent conductive layer comprises ITO conductive glass or FTO conductive glass; the material of the passivation layer comprises phenylethylamine iodide or ethylamine iodide; the material of the first metal electrode layer comprises one of Au, Ag, Cu, Cu-Al alloy, and C; and the material of the second metal electrode layer comprises one of Au, Ag, Cu, Cu-Al alloy and C.

Obviously, the above examples are merely examples made for clear description, rather limiting the implementations. For those of ordinary skill in the art, other different forms of variations or modifications can also be made on the basis of the above-mentioned description. All embodiments are not necessary to be and cannot be exhaustively listed herein. In addition, obvious variations or modifications derived therefrom all fall within the scope of protection of the present application.

## Claims

1. A method for manufacturing a perovskite solar cell, comprising
forming a perovskite layer of the perovskite solar cell, wherein the forming of the perovskite layer comprises the following steps:
forming an inorganic precursor solution and further forming an inorganic precursor membrane layer, wherein solvent of the inorganic precursor solution comprises a mixture of N,N-dimethylformamide (DMF) and dimethyl sulfoxide (DMSO), wherein an inorganic precursor material forming the inorganic precursor solution comprises at least CsX and PbX₂, and wherein X in CsX is Br or I, and X in PbX₂ is I;
forming an organic precursor solution, applying the organic precursor solution on a surface of the inorganic precursor membrane layer, and mixing with the inorganic precursor membrane layer to form a mixed precursor solution layer, wherein an organic precursor material of the organic precursor solution comprises at least two of formamidinium halides (FAX) and methylamine halides (MAX), and wherein X in FAX is Br or I, and X in MAX is Cl; and
performing diffusion annealing to transform the mixed precursor solution layer into the perovskite layer.

2. The method for manufacturing a perovskite solar cell according to claim 1, wherein
the step of forming an inorganic precursor solution and further forming an inorganic precursor membrane layer comprises:
mixing two or more inorganic precursor materials according to their corresponding preset molar contents, and modulating to form the inorganic precursor solution;
spreading the inorganic precursor solution on a substrate to form into a membrane layer, wherein the spreading mode comprises spin coating; and
performing annealing to the spreaded inorganic precursor solution to form the inorganic precursor membrane layer, wherein the inorganic precursor membrane layer is a liquid membrane layer.

3. The method for manufacturing a perovskite solar cell according to claim 2, wherein
in the inorganic precursor solution, a molar content of CsX and a molar content of PbX₂ are different;
the molar content of CsX is in a range from 0.10 mol/L to 0.20 mol/L;
the molar content of PbX₂ is in a range from 1.00 mol/L to 2.00 mol/L;
in the mixture of DMF and DMSO solvent, a ratio of DMF to DMSO is in a range from (900:100) to (990:10);
preferably, in the mixture of DMF and DMSO solvent, the ratio of DMF to DMSO is 950:50; and
in the inorganic precursor solution, a difference between the molar content of CsX and the molar content of PbX₂ is 0.1 mol/L.

4. The method for manufacturing a perovskite solar cell according to claim 1, wherein
the step of, forming an organic precursor solution, applying the organic precursor solution on a surface of the inorganic precursor membrane layer, and mixing with the inorganic precursor membrane layer to form a mixed precursor solution layer, comprises:
modulating at least two organic precursor materials according to corresponding preset molar contents into the organic precursor solution, wherein the solvent of the organic precursor solution comprises isopropanol (IPA); and
spreading the organic precursor solution on the surface of the inorganic precursor membrane layer and mixing, wherein the spreading mode comprises spin coating.

5. The method for manufacturing a perovskite solar cell according to claim 4, wherein
in the organic precursor solution, the organic precursor material comprises formamidinium iodide (FAI), formamidinium bromide (FABr) and methylamine chloride (MACl); and
in the organic precursor solution, the content of FAI is in a range from 0.12 mol/L to 0.22 mol/L, the content of FABr is in a range from 0.16 mol/L to 0.32 mol/L, and the content of MACl is 0.1 mol/L.

6. The method for manufacturing a perovskite solar cell according to claim 1, wherein
in the step of performing diffusion annealing to transform the mixed precursor solution layer into the perovskite layer:
an annealing temperature is in a range from 100 °C to 200 °C;
an annealing time is in a range from 10 min to 60 min; and
an ambient humidity is in a range from 20% to 60% relative humidity.

7. The method for manufacturing a perovskite solar cell according to claim 1, further comprising:
providing a substrate layer;
forming an i-type hydrogenated amorphous silicon layer, a P-type amorphous silicon doping layer, a first transparent electrode layer and a first metal electrode layer laminated in sequence on a surface of one side of the substrate layer; and
forming an i-type hydrogenated amorphous silicon layer, a N-type amorphous silicon doping layer, a transparent conductive layer, a hole transport layer, a passivation layer, an electron transport layer, a second transparent conductive layer, a second metal electrode layer and an anti-reflection layer laminated in sequence on a surface of the other side of the substrate layer; and
wherein, the perovskite layer is formed on a surface of one side of the hole transport layer facing away from the substrate layer; and the passivation layer is formed on a surface of one side of the perovskite layer facing away from the substrate layer.

8. A perovskite solar cell, which is manufactured using the method for manufacturing a perovskite solar cell according to any one of claims 1 to 7; wherein
the perovskite solar cell comprises a single-junction perovskite cell device, a perovskite-perovskite laminated cell or a perovskite heterojunction laminated cell and other laminated cells containing a perovskite cell portion.

9. The perovskite solar cell according to claim 8, wherein the perovskite solar cell comprises:
a substrate layer;
an i-type hydrogenated amorphous silicon layer, a P-type amorphous silicon doping layer, a first transparent electrode layer and a first metal electrode layer which are laminated in sequence on one side of the substrate layer;
an i-type hydrogenated amorphous silicon layer, a N-type amorphous silicon doping layer, a transparent conductive layer, a hole transport layer, a passivation layer, an electron transport layer, an electron transport layer modification layer, a second transparent conductive layer, a second metal electrode layer and an anti-reflection layer which are laminated in sequence on the other side of the substrate layer; and
a perovskite layer which is located between the hole transport layer and the passivation layer.

10. The perovskite solar cell according to claim 9, wherein
the first transparent conductive layer comprises Indium Tin Oxide (ITO) conductive glass or Fluorine-doped Tin Oxide (FTO) conductive glass;
the second transparent conductive layer comprises ITO conductive glass or FTO conductive glass;
the material of the passivation layer comprises phenylethylamine iodide or ethylamine iodide;
the material of the first metal electrode layer comprises one of Au, Ag, Cu, Cu-Al alloy, and C; and
the material of the second metal electrode layer comprises one of Au, Ag, Cu, Cu-Al alloy and C.
